Europäisches Patentamt

European Patent Office

Office européen des brevets

(11) Publication number: **0 060 784**
**B1**

# EUROPEAN PATENT SPECIFICATION

(45) Date of publication of patent specification: **17.07.85**

(21) Application number: **82400447.7**

(22) Date of filing: **12.03.82**

(51) Int. Cl.⁴: **C 03 C 3/097, H 01 L 21/316, H 01 L 21/473, H 05 K 1/05, H 05 K 3/28**

(54) **Low melting temperature glass for use over aluminium interconnects of an integrated circuit structure.**

(30) Priority: **16.03.81 US 243988**

(43) Date of publication of application:
**22.09.82 Bulletin 82/38**

(45) Publication of the grant of the patent:
**17.07.85 Bulletin 85/29**

(84) Designated Contracting States:
**DE FR GB IT NL**

(56) References cited:
**US-A-3 669 693**

(73) Proprietor: **FAIRCHILD CAMERA & INSTRUMENT CORPORATION**
**464 Ellis Street**
**Mountain View California 94042 (US)**

(72) Inventor: **Pierce, John M.**
**3332 Middlefield Road**
**Palo Alto California 94306 (US)**
Inventor: **Lehrer, William I.**
**1161 Seena Avenue**
**Los Altos California 94022 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

EP 0 060 784 B1

Courier Press, Leamington Spa, England.

## Description

### Background of the invention
### Field of the invention

This invention relates to integrated circuits and in particular to such circuits wherein a glass film with a smooth surface is provided on the integrated circuit over the interconnect structure on the integrated circuit. This invention is particularly useful when the interconnect structure is aluminum or an alloy of aluminum.

### Description of the prior art

The use of glass film overlying aluminum interconnections on integrated circuits is well known. Unfortunately, because prior art glass films melt at a temperature significantly above that of the aluminum, once such a glass film is formed, the topography of the surface of the glass film is permanently fixed. Accordingly, should it be desired to smooth the glass film to allow a second level of interconnects to be formed over the glass film, the underlying aluminum melts. To avoid this problem, first level interconnects are often formed of some material other than aluminum selected to have a melting temperature above that of the insulating glass formed over the interconnect leads. This often raises the impedance of the interconnects and slows the circuit.

### Summary of the invention

It is a general object of this invention to provide a glass composition which has a melting point below that of aluminum.

This and other objects are attained, in accordance with one aspect of the invention by a low temperature insulation glass for use in semiconductor devices, said insulating glass being a mixture of about 45% to 50% $SiO_2$, about 50% to 45% of $GeO_2$ and about 5% of $P_2O_5$, by weight.

Another aspect of the invention includes an integrated circuit structure comprising: a semiconductor material; insulation formed on said semiconductor material; interconnect leads comprising aluminum formed on said insulation and selectively brought into contact with the underlying semiconductor material through openings in said insulation; and a glass layer formed on said interconnect leads said glass layer consisting of a mixture of about 45% to 50% $SiO_2$, about 50% to 45% $GeO_2$ and about 5% of $P_2O_5$, by weight.

### Detailed description of the invention

The glass of this invention comprises a mixture of silicon, germanium, oxygen, and phosphorus. The composition is in the range of approximately 45—50% $SiO_2$, 50—45% $GeO_2$, and about 5% $P_2O_5$, by weight. Of course, the actual percentages of each constituent are such that the total of the weight percentages of all the constituents is 100%. By selecting the composition to be in these ranges, the melting or softening temperature of the glass is brought low enough such that the surface of the glass can be reflowed without damaging the aluminum interconnects formed beneath the glass.

In accordance with this invention, the use of a high pressure, as disclosed in European patent application 82 400450.1, publication number 0060785 (filed on the same day as this invention on an invention of Reda Razouk entitled "Method of Inducing Flow or Densification of Phosphosilicate Glass for Integrated Circuits" and assigned to Fairchild Camera and Instrument Corporation, the assignee of this application), can be used to further lower the melting temperature of the glass. The use of pressure to accelerate flow is desirable since the temperature window between the highest temperature to which the aluminum interconnect can be heated without damage (typically about 540°C but in general dependent upon the aluminum alloy used) and the highest temperature used in subsequent processing is small. The glass softening point should be kept high enough to avoid softening of the glass during later processing for alloy cycles or die attach. For this reason the natural flow of glass is made to take place at a temperature quite close to that of the melting of aluminum alloys. In another approach using temperature pulse techniques involving lasers, a temperature difference between the glass and the underlying interconnect material can be sustained and the glass can be selectively reflowed at a localized temperature somewhat higher than the melting temperature of the aluminum alloy without damaging the underlying alloy interconnect structure.

The glass used here is similar in its properties to phosphosilicate glasses commonly used in the prior art but flows at a much lower temperature. While the prior art phosphosilicate glass flowed, it did so at a temperature much too high to allow it to be used over aluminum or organic dielectrics such as polyimide (which tends to absorb water).

The above description is exemplary only and other embodiments of this invention will be obvious to those skilled in the semiconductor glass arts in view of this disclosure.

## Claims

1. A low temperature insulation glass for use in semiconductor devices, said insulating glass being characterized by a mixture of about 45% to 50% $SiO_2$ about 50% to 45% of $GeO_2$ and about 5% of $P_2O_5$, by weight.

2. An integrated circuit structure comprising:
   a semiconductor material;
   insulation formed on said semiconductor material;
   interconnect leads comprising aluminum formed on said insulation and selectively brought into contact with the underlying semiconductor material through openings in said insulation; and characterized by
   a glass layer formed on said interconnect leads, said glass layer consisting of a mixture of about 45% to 50% $SiO_2$, about 50% to 45% of $GeO_2$ and about 5% of $P_2O_5$, by weight.

3. Structure as in Claim 2 characterized in that said glass layer has a substantially smooth surface.

**Patentansprüche**

1. Niedertemperatur-Isolationsglas zur Verwendung in Halbleiteranordnungen, gekennzeichnet durch ein Gemisch von etwa 45 bis 50 Gew.-% $SiO_2$, etwa 50 bis 45 Gew.-% $GeO_2$ und etwa 5 Gew.-% $P_2O_5$.

2. Integrierte Schaltkreisstruktur, umfassend:
ein Halbleitermaterial;
auf besagtem Halbleitermaterial gebildete Isolation;
Verbindungsleitungen, umfassend Aluminium auf der Isolation und selektiv in Kontakt gebracht mit dem darunterliegenden Halbleitermaterial durch Öffnungen in der besagten Isolation, gekennzeichnet durch
eine Glasschicht, die auf besagten Verbindungsleitungen gebildet ist und aus einem Gemisch von etwa 45 bis 50 Gew.-% $SiO_2$, etwa 50 bis 45 Gew.-% $GeO_2$ und etwa 5 Gew.-% $P_2O_5$ besteht.

3. Struktur nach Anspruch 2, dadurch gekennzeichnet, daß die Glasschicht eine weitgehend glatte Oberfläche hat

**Revendications**

1. Verre isolant à basse température de fusion utilisable dans des dispositifs à semiconducteurs, ledit verre isolant étant caractérisé par un mélange d'environ 45 à 50% de $SiO_2$, environ 50 à 45% de $GeO_2$ et environ 5% de $P_2O_5$ en poids.

2. Structure de circuit intégré comprenant:
un matériau semiconducteur;
un isolant formé sur le matériau semiconducteur;
des bornes d'interconnexion comportant de l'aluminium, formées sur ledit isolant et en contact sélectif avec le matériau semiconducteur sous-jacent par des ouvertures dans ledit isolant; caractérisée par:
une couche de verre formée sur lesdites bornes d'interconnexion, ladite couche de verre consistant en un mélange d'environ 45 à 50% de $SiO_2$, environ 50 à 45% de $GeO_2$ et environ 5% de $P_2O_5$ en poids.

3. Structure selon la revendication 2, caractérisé en ce que ladite couche de verre a une surface sensiblement lisse.